# EUROPEAN PATENT APPLICATION

(11) **EP 0 523 414 A1**
(43) Date of publication of application: **20.01.1993**
(21) Application number: 92110687.8
(22) Date of filing: 25.06.1992
(51) Int. Cl.: H01L 21/00

(54) **Wafer mounting device**

(30) Priority: 26.06.1991 JP 56783/91
(71) Applicant: ENYA SYSTEMS LIMITED, Kawagoe-shi, Saitama-ken (JP)
(72) Inventor: Yokosuka, Noriyoshi, Iruma-shi, Saitama-ken (JP); Suzuki, Shizuo, Oume-shi, Tokyo (JP)
(74) Representative: Klingseisen, Franz, Dipl.-Ing.

(57) **Abstract**

A wafer mounting device wherein a wafer coated with an adhesive on the surface, can be pasted on a mount plate while maintaining the thickness of an adhesive layer uniform. At the top of the arm, a chuck plate is disposed in such a way that it can be moved in a direction of rotation of the arm. This chuck plate is heated by a heater to the substantially same temperature as the wafer. Between the chuck plate and the arm are provided, a pressing pad for biasing the chuck plate in a direction being away from the arm, and a pressure-adjusting pad for biasing the chuck plate in a direction being close to the chuck plate. The pressing pad and the pressure-adjusting pad are formed to have hollow sections within which pressurizing fluids are supplied, thereby controlling the pressing force of the chuck plate so that the wafer is placed softly on the mount plate.

## Description

### BACKGROUND OF THE INVENTION

### (1) Field of the Invention

The present invention relates to a wafer mounting device in which a wafer is pasted uniformly upon a mount plate which supports the wafer for polishing it smooth.

### (2) Background Information

In the production of semiconductor, it has been conducted to paste wafers upon a mount plate of a polishing machine with an adhesive to polish the surface of the wafers. In this case, if the adhesive layer is formed uneven, its influence tends to arise on the surface to be polished, and it becomes impossible to polish the wafers flatly with high precision. Further, since such mounting operation is carried out by manual operation, it is difficult to form the adhesive layer evenly and the efficiency is not good.

The applicant has proposed a process wherein an adhesive diluted with an organic solvent or an aqueous alkali solution, is applied thinly on the surface of the wafer with a spin coater, and the wafer is reversed and sequentially and continuously pasted on a mount plate, and a device therefor.

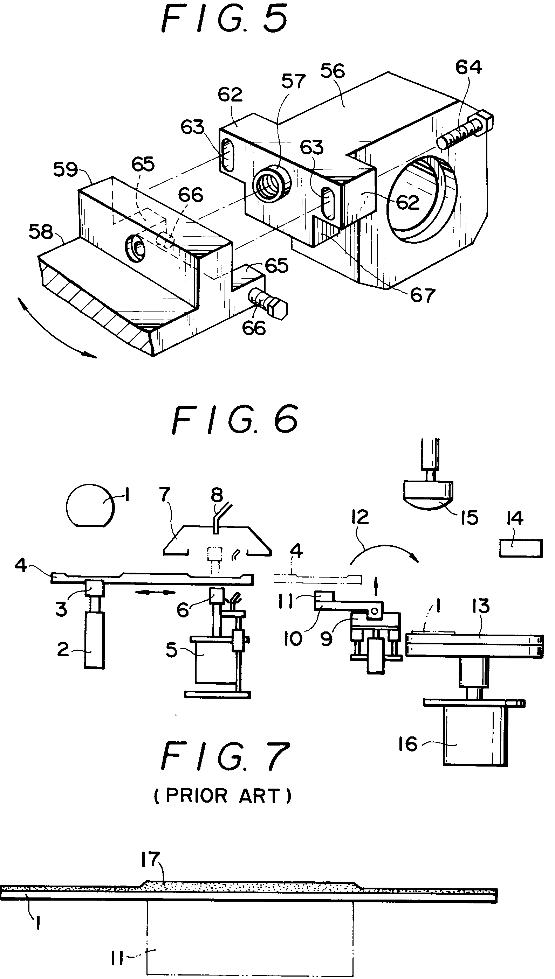

Fig. 6 shows a basic structure of the process, wherein a wafer 1 is placed horizontally on a conveying means 4 by moving up or down a holding section 3 of a receiving device 2, and the wafer is conveyed above a spin chuck means 5 by laterally moving the conveying means. A holding section 6 of the spin chuck means 5 moves up and carries the wafer into an adhesive coating device 7. Then, the wafer spins round and the adhesive is dropped from a nozzle 8 to apply it thinly on the surface of the wafer. The wafer 1 is again placed on the conveying means 4 by moving down the holding section 6 of the spin chuck means 5.

The conveying means which has received the wafer, is laterally moved to the position shown by the chain line. Corresponding to this position, a mounting device 9 is disposed. The mounting device 9 has a chuck plate 11 at the top of an arm 10. When the arm 10 is turned as shown by an arrow 12, it holds by suction, the wafer on the conveying means, and places the wafer on the upper surface of a mount plate 13. The mount plate 13 has been heated to a predetermined temperature, and a heating means 14 is adequately disposed around it, so that the evaporation of the organic solvent or the aqueous alkali solution in the adhesive can be accelerated to solidify the adhesive and effect the adhesion fast. Above the mount plate 13, a stamp means 15 is disposed to press the wafer 1 mounted on the mount plate 13 against the mount plate 13. Then, the mount plate 13 is rotated by a predetermined angle by use of an indexing means 16 to paste the wafers sequentially thereon. Once plural wafers are pasted, the mount plate 13 is conveyed to the following step from the indexing means, and the mount plate is cooled together with the plural wafers to solidify the adhesive completely.

In the process of mounting the wafers, since the adhesive is applied by spin coating, the adhesive is heated to an adequate temperature and has a fluidity. Therefore, when the chuck plate 11 of the mounting device holds the wafer 1 by suction, if the temperature of the chuck plate 11 is low as compared with the wafer 1 coated with the adhesive, the fluidity of an adhesive 17 at the portion being in contact with the chuck plate 11 as shown in Fig. 7 tends to be poor, and thus it becomes possible to form an even adhesive layer on the whole surface of the wafer.

Further, when the wafer 1 is held by suction by the chuck plate 11, and the wafer is pasted on the mount plate 13 by turning the arm 10, if the force of the chuck plate 11 to press the wafer 1 against the mount plate is strong, it is sometimes caused that the thickness of the adhesive layer at the portion pressed directly by the chuck plate and the thickness of the adhesive layer at the peripheral portion thereof become different.

### SUMMARY OF THE INVENTION

An object of the present invention is to provide a wafer mounting device by which a wafer can be pasted on the mount plate so as not to make the thickness of the adhesive layer applied on the wafer uneven.

Another object of the present invention is to provide a wafer mounting device wherein the thickness of the adhesive layer does not because uneven by finely adjusting the pressing force when the wafer is pasted on the mount plate.

According to the present invention, the above objects can be accomplished by a wafer mounting device comprising a heater for heating the chuck plate holding the wafer to the substantially same temperature as the temperature of the wafer.

Further, according to the present invention, the above objects can also be accomplished by a wafer mounting device which comprises an arm, a chuck plate disposed at the top of the arm in such a way that the chuck plate can be moved in a direction of rotation of the arm, a pressing pad for urging the chuck plate toward in a direction being away from the arm, and a pressure-adjusting pad for urging the chuck plate in a direction being close to the arm, whereby the pressing force of the chuck plate can be adjusted.

Other objects and features of the present invention will because apparent to those skilled in the art upon reading the following description with reference to the accompanying drawings.

### BRIEF DESCRIPTION OF THE DRAWINGS

Fig. 1 is an enlarged cross sectional view of a top section of an arm of a wafer mounting device of the present invention.

Fig. 2 is an enlarged cross sectional view of a top section of the arm under the condition that the wafer. is reversed and pasted on a mount plate.

Fig. 3 is a side view of the wafer mounting device of the present invention.

Fig. 4 is a partially cross sectional view of another embodiment of the arm of the wafer mounting device of the present invention.

Fig. 5 is an exploded perspective view of the arm shown in Fig. 4.

Fig. 6 is an explanatory view showing an automatic wafer mounting step using the wafer mounting device of the present invention.

Fig. 7 is an enlarged side view of the wafer held by a chuck plate in the wafer mounting device of a prior art.

### DESCRIPTION OF THE PREFERRED EMBODIMENTS

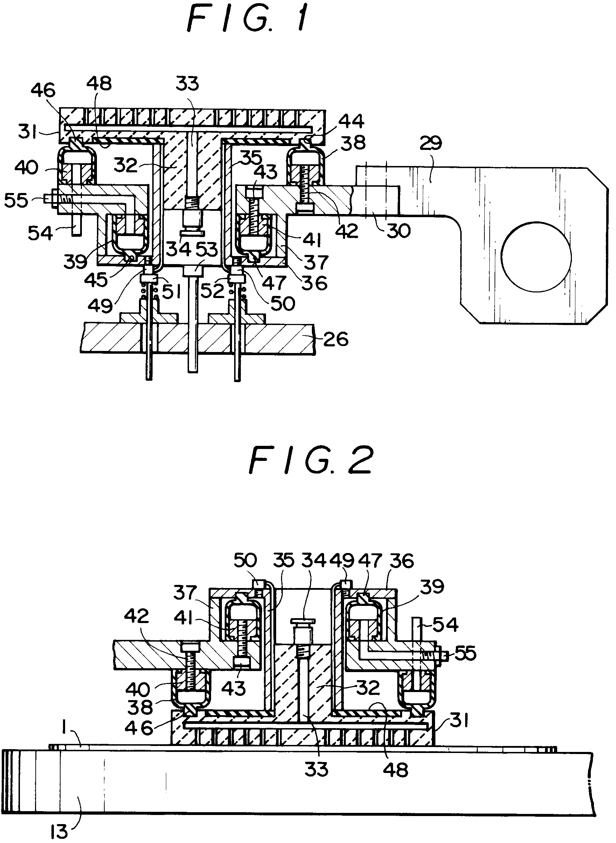

With reference to Figs. 1 to 3, a body of the device 18 is provided with a lateral moving frame 22 which is guided by a guide rod 19 and moved in a direction of an arrow 21 by a cylinder 20, and a longitudinal moving frame 26, mounted on the lateral moving frame 22, which is guided by a guide rod 23 and moved in a direction of an arrow 25 by a cylinder 24. The longitudinal moving frame 26 is provided with an arm 29 pivotally mounted by a pivot shaft 28 so as to rotate by means of a rotating means 27 such as a motor or an air actuator. The entire body of the device 18 may be moved up or down.

At the end of the arm 29, a mounting plate 30 is detachably fixed. The mounting plate 30 is provided with a chuck means. However, the chuck means may be attached directly to the arm 29 without forming the mounting plate 30. The chuck means may have various structures. In the drawing, the chuck means is provided with a chuck plate 31 made of a ceramic material, a through hole 33 formed within a shaft 32 of the plate 31 so as to effect suction by vacuum at the upper surface of the chuck plate 31, a connecting pipe 34 which connects the through hole and a vacuum source separately mounted (not shown in the drawing), and the like.

The shaft 32 of the chuck plate 31 is fixed to a supporting cylinder 35 which is slidably inserted into the mounting plate 30. A supporting plate 36 is formed at the edge of the supporting cylinder 35. As mentioned above, the chuck plate 31 is disposed so that it may move in a direction of rotation of the arm. The arm 29 has a protruding wall 37 formed to abut to the supporting plate 36.

Between the plate 31 of the chuck means and the mounting plate 30 of the arm 29, and between the supporting plate 36 and the mounting plate 30, a hollow pressing pad 38 and a pressure adjusting pad 39 are provided. The pads 38, 39 are made of an elastic material having a heat resistance, such as a silicone rubber material, and are formed annularly. The pads have an opening at the lower surface, and have cross section of a substantially C-shape. Holding plates 40, 41 are each inserted through the openings. The lower edges of the pods are clamped between the mounting plate 30 and the holding plates, and are fixed by bolts 42, 43 to the mounting plate 30.

On the upper surface of the pads 38, 39, are provided engaging projections 46, 47 spaced appropriately in a direction of rotation, which are inserted into engaging slots 44, 45 formed on the chuck plate 31 and the supporting plate 36, so as to prevent lateral movement of the pads. Between the engaging projections, supporting stripes (not shown in the drawing) are appropriately disposed in a circumferential direction for supporting the plate 31 or the supporting plate 36.

Further, the chuck plate 31 is provided with a heater 48 for heating the plate to the substantially same temperature as the wafer 1. The heater 48 used in the example shown in the drawing, is a rubber heater attached to the back surface of the plate 31. The wiring of the heater 48 is connected to terminals 49, 50 attached to the supporting plate 36. The longitudinal moving frame 26 is provided with terminals 51, 52 which are connected to the electric source and resiliently mounted by springs. The terminals 51, 52 are adjusted to be connected to the terminals 49, 50 to apply electric current to the heater 48, when the arm 29 is under the condition shown in Fig. 1. The temperature of the chuck plate 31 is detected by a temperature sensor 53, thereby controlling the electric current to the heater by the detected signals.

The heater 48 used in this example shown in the drawing, is directly attached to the chuck plate, but may be disposed in adjacent to the chuck plate. The chuck plate may be heated by other appropriate method.

Pressurizing means are provided to introduce a pressurizing fluid into the pods 38, 39, and maintain the pressure within each of the pods at a predetermined pressure. The pressurizing means shown in the drawing, has a circuit wherein a fluid (gas) such as nitrogen gas or air from the pressurizing fluid supplying source (not shown in the drawing), is adjusted to a pressure of about 0.01 to 1 kg/cm² by means of a fluid stop valve, a precision regulator, etc., and is supplied to the pad 38 through a pipe 54 and to the pad 39 through a pipe 55.

The pressure of the pressure adjusting pad 39 is controlled so that the chuck plate 31 does not press the wafer 1 unnecessarily strong against the mounting plate 13 by the pressing pad 38.

The fluid supplying circuit is provided with a digital pressure switch so as to detect the reduction of the pressure when the pad is broken or the connecting pipe is detached thereby resulting in the sharp reduction of the inner pressure of the pad, and to stop the introduction of the pressurizing fluid and at the same time stop the entire body of the device shown in Fig. 6.

Further, when the mounting device is used under the clean or ultra clean condition so that the dust particles do not adhere to the surface of the mounting plate, the circuit may have a structure wherein a dust counter (not shown in the drawing) is disposed adjacent to the device for counting the dust particles around it, and, once, for example, the pressurizing fluid is ejected and the counter counts a predetermined number of the dust, a solenoid valve (not shown in the drawing) placed at adequate portion of the circuit, is controlled to stop the introduction of the pressurizing fluid and stop the entire device.

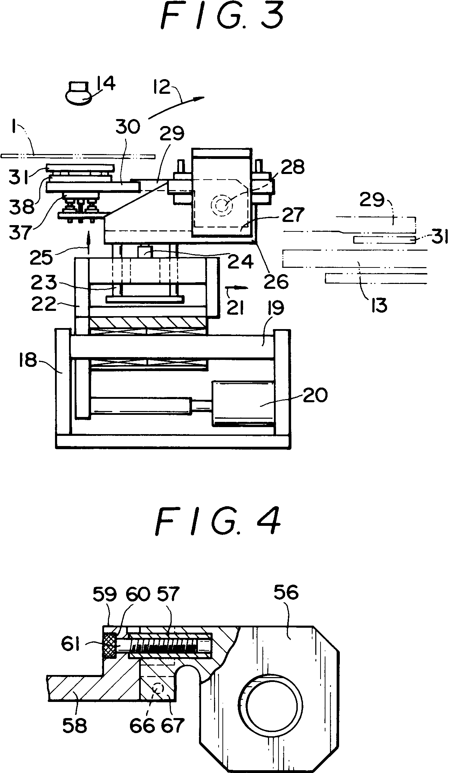

Thus, as shown in Fig. 3, when the arm 29 of the wafer mounting device is moved up in a direction of an arrow 25, the wafer 1 coated with the adhesive on the surface is held by the chuck means, reversed by turning the arm 29 in a direction of an arrow 12 as shown in Fig. 6, and placed on the mounting plate 13 as shown in Fig. 2. In this time, the chuck plate 31 is heated to the substantially same temperature as the wafer 1 by the heater 48, no temperature difference is caused between the portion at which the wafer is held by suction by the chuck plate and the other portions of the wafer, whereby the fluidity of the adhesive does not because ununiform and the thickness of the adhesive layer does not become uneven.

Further, as shown in Fig. 2, when the wafer 1 is placed on the mount plate 13 by turning the arm 29, the chuck plate 31 receives urging action downwardly by the pressing pad 38 and urging action upwardly by the pressure adjusting pad 39. However, by adjusting the pressures of the pressurizing fluid which are applied to the pads 38, 39, the movement of the chuck plate 31 can be controlled so as to place the wafer 1 on the mounting plate 13 softly. By such control, it is possible to prevent unevenness of the thickness of the adhesive layer due to the applied pressure by the chuck plate.

In the above examples, the mounting plate 30 disposed at the top of the arm 29, can be properly changed or detached depending upon the sizes of the wafers. However, when the body of the device 18 is not positioned horizontally relative to the mounting plate 13, a mounting plate may be rotatably connected to the arm so as to adjust the position.

Figs. 4 and 5 show the examples, wherein a guide cylinder 57 is fixed to the top of an arm 56, and a receiving slot 60 formed in a rising wall 59 of a mounting plate 58, is fitted to the guide cylinder 57 in such a manner that the mounting plate 58 can be freely rotated, and fixed by means of a bolt 61. At wing sections 62, 62 of the arm 56, elongated slots 63, 63 are formed. A bolt 60 is inserted through the elongated slots 63, 63 in such a manner as to be freely movable, and screwed to the rising wall 59 of the mounting plate 58, whereupon the slant of the mounting plate is adjusted as mentioned below, and the mounting plate 58 and the arm 56 are fastened at a predetermined position.

Further, to lug sections 65, 65 projecting toward the arm from the rising wall 59, adjusting bolts 66, 66 are screwed from each side to face each other. The tops of the bolts are made to abut to the both side surfaces of a vertical wall 67 of the arm 56.

By the above structure, the chuck plate can be rotated around the axis of the arm as a center. Therefore, by changing the amount of screwing the bolts 66, 66 facing each other, the mounting plate can be rotated with the guide cylinder as a center and the mounting angle of the chuck plate relative to the arm 56 can be changed, whereby the chuck plate 31 can be disposed under properly horizontal condition against the mounting plate 13.

According to the present invention constituted as mentioned above, the wafer can be pasted on the mounting plate so as not to make the thickness of the adhesive layer applied on the wafer uneven.

## Claims

1. A wafer mounting device wherein a wafer coated with an adhesive on the surface, is held by a chuck and reversed and-pasted on a mount plate,
**characterised in that**
the wafer mounting device comprises an arm (29), (56) rotatably disposed, a chuck plate (31) disposed at the top of the arm to hold the wafer by suction, and a heater (48) for heating the chuck plate (31) to the substantially same temperature as the wafer.

2. The wafer mounting device according to claim 1, wherein the heater (48) is disposed at the back of the chuck plate (31).

3. The wafer mounting device according to claim 1, which further comprises, between the chuck plate (31) and the arm (29) a pressing pad (38) for urging the chuck plate (31) in a direction being away from the arm (29).

4. The wafer mounting device according to claim 3, wherein the pressing pad (38) is formed to have a hollow section within which a pressurizing fluid is supplied.

5. The wafer mounting device according to claim 3, wherein a supporting plate (36) communicating with the chuck plate (31) is disposed on the opposite side of the chuck plate (31) with the arm (29) between, and a pressure-adjusting pad (39) for urging the chuck plate (31) in a direction being close to the arm (29), is disposed between the supporting plate (36) and the arm (29).

6. The wafer mounting device according to claim 5, wherein the pressure-adjusting pad (39) is formed to have a hollow section within which a pressurizing fluid is supplied.

7. The wafer mounting device according to claim 1, wherein the chuck plate (31) is rotatably disposed with the axis of the arm as a center.
